# EUROPÄISCHE PATENTSCHRIFT

(11) **EP 0 339 329 B1**
(45) Veröffentlichungstag und Bekanntmachung des Hinweises auf die Patenterteilung: **05.02.1997**
(21) Anmeldenummer: 89106116.0
(22) Anmeldetag: 07.04.1989
(51) Int. Cl.: H03J 7/18

(54) **Rundfunkempfänger mit einem Decoder**
Radio receiver with a decoder
Récepteur radio avec un décodeur

(30) Priorität: 23.04.1988 DE 3813783
(43) Veröffentlichungstag der Anmeldung: 02.11.1989
(73) Patentinhaber: Blaupunkt-Werke GmbH, D-31132 Hildesheim (DE)
(72) Erfinder: Hegeler, Wilhelm, D-3200 Hildesheim (DE)

(56) Entgegenhaltungen:
- EP-A- 0 201 681
- DE-A- 2 051 034
- DE-A- 2 229 796
- DE-A- 3 019 770

## Beschreibung

Die Erfindung geht von einem Rundfunkempfänger mit einem Decoder für einem 57-kHz-Hilfsträger aufmodulierte Signale und einer programmierbaren Suchlaufschaltung nach dem Oberbegriff des Hauptanspruchs aus.

Rundfunkempfänger dieser Art sind aus der DE-A-22 29 796 bekannt. Die dort angegebene Schaltung arbeitet mit einem Zeitverzögerungsglied, das aus einem RC-Netzwerk besteht. Durch die Dimensionierung dieses Netzwerkes ist eine bestimmte Zeitverzögerung vorgegeben. Bei der Konzeption der Schaltung geht man davon aus, daß bestimmte Sender durch ein Pilotsignal gekennzeichnet sind.

Des weiteren sind aus der EP-A-0 201 681 mobil einsetzbare Rundfunkempfänger bekannt, die über eine Auswertung des Bewegungszustandes des Fahrzeuges oder des am Ort des Empfängers vorhandenen Feldstärke- und/oder Störspannungsverlaufs verfügen. In Abhängigkeit dieser Kriterien erfolgt eine Umschaltung einer Zeitkonstanten für die Verzögerung des Suchlaufstarts, so daß der Suchlaufstart bei stehendem Fahrzeug oder konstanter Feldstärke/Störspannung mit einer ersten Zeitkonstanten, bei bewegtem Fahrzeug oder schwankender Feldstärke/Störspannung mit einer zweiten kleineren Zeitkonstanten verzögert wird. Dadurch wird gewährleistet, daß der Suchlauf bei einzelnen örtlich begrenzt auftretenden Empfangsstörungen nicht zu früh, bei häufig auftretenden Empfangsstörungen nicht zu spät gestartet wird.

Im Zuge der Weiterentwicklung der Signalübertragung im UKW-Rundfunkbereich wird inzwischen das Pilotsignal, der 57-kHz-Hilfsträger der Verkehrsfunksender, mit einer Bereichskennung und zeitweise einer Durchsagekennung in der Amplitude moduliert und nach neueren Vorschlägen auch mit dem RDS-Signal. Die Übertragung der Verkehrsfunkkennung erfolgt nach der Lehre des Anspruchs 1 des DE-A-20 51 034, die Übertragung des RDS-Signals nach Anspruch 2 desselben Patents.

Aus der DE-A-3 019 770 ist ein Suchlaufempfänger für UKW-Verkehrsfunksender, die einen amplitudenmodulierten 57-kHz-Hilfsträger ausstrahlen, bekannt, wobei die Suchlaufgeschwindigkeit verringert wird, sobald ein Sender genügender Empfangsqualität empfangen wird. Handelt es sich bei dem empfangenen Sender um einen UKW-Verkehrsfunksender, was am Vorhandensein und der Modulation des 57-kHz-Hilfsträgers erkannt wird, so wird die Fortsetzung des Suchlaufs unterbunden, ansonsten mit der wieder auf den ursprünglichen Wert erhöhten Geschwindigkeit fortgesetzt. Es wird damit erreicht, daß der Sendersuchlauf nur beim Empfang eines UKW-Verkehrsfunksenders unterbrochen wird.

Es wurde bereits diskutiert, neben der Kennzeichnung von Durchsagen von Verkehrsmeldungen, die Durchsagen anderer Meldungen, insbesondere allgemeiner Warnmeldungen zu kennzeichnen. Die Unterscheidung zwischen den verschiedenen Durchsagekennungen benötigt aus systembedingten Gründen eine längere Erkennungszeit als die Erkennung einer Bereichskennung.

Im RDS-Signal werden Kennsignale für verschiedene Eigenschaften des Senders bzw. der Sendung, nach denen ein Suchlauf suchen könnte, nacheinander übertragen und unterschiedlich häufig wiederholt, je nachdem, in welcher Gruppe des RDS-Signals das Kennsignal übertragen wird.

Der Erfindung lag nun die Aufgabe zugrunde, die bekannte Schaltung von der Dimensionierung auf die sehr selten übertragenen Kennsignalen oder auf die Erkennung unterschiedlicher Durchsagekennungen zu lösen und den Sendersuchlaufvorgang zu beschleunigen.

Die Lösung dieser Aufgabe gemäß der Erfindung ist bei einem Rundfunkempfänger nach dem Oberbegriff des Anspruch 1 im kennzeichnenden Teil des Anspruchs 1 näher angegeben.

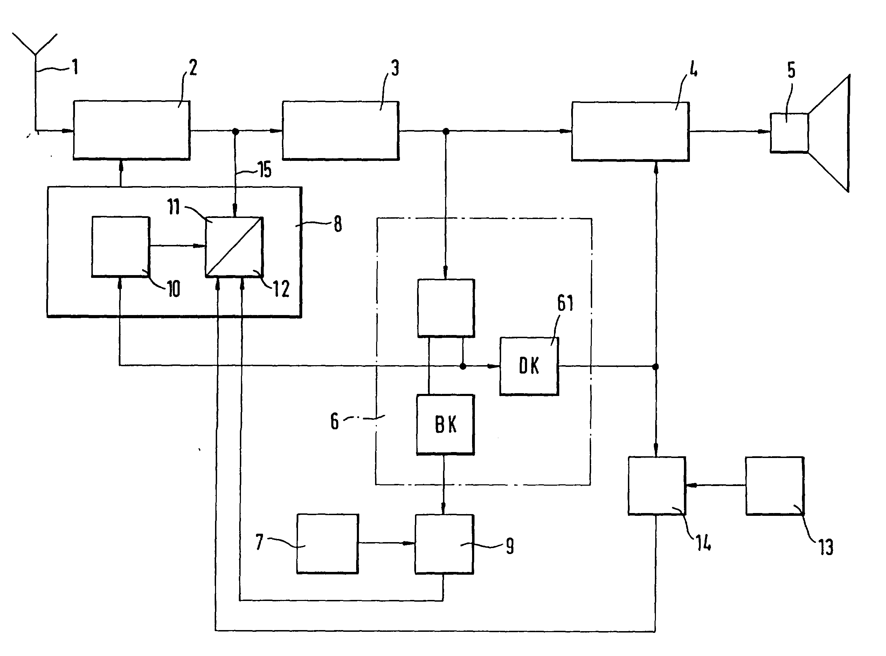

Anhand eines Blockschaltbildes, Figur 1, wird diese Lösung ausführlicher erläutert.

Die Antenne 1 erzeugt bei dem Empfang der Rundfunksender ein Eingangssignal für den Rundfunkempfänger, der ein HF-Teil 2, ein ZF-Teil 3 und ein NF-Teil 4 umfaßt, an den der Lautsprecher 5 angeschlossen ist.

Am Ausgang des ZF-Teils 3 ist bei Verkehrsfunk- oder RDS-Sendern neben dem NF-Signal auch ein 57-kHz-Hilfsträger abgreifbar, der im Ausführungsbeispiel dauernd mit einer Bereichskennung im Frequenzbereich von etwa 20 - 50 Hz und von Zeit zu Zeit mit Durchsagekennungen von 125 Hz und darüber in der Amplitude moduliert ist.

In einem Verkehrsfunkdecoder 6 wird der 57-kHz-Hilfsträger demoduliert und an dem einen der beiden Ausgänge steht die Bereichskennung, am anderen die Durchsagerkennung an.

Der Rundfunkempfänger verfügt über eine sogenannte aktive Bereichskennungsschaltung. Diese besteht aus einer Tastatur 7, mit der die Bereichskennung vorgewählt werden kann, die ein Autofahrer gerade bevorzugt.

Zum leichteren Verständnis sei kurz erläutert, daß die Hilfsträger der Sender in einem bestimmten geografischen Bereich mit der gleichen Bereichskennung moduliert sind, um damit kenntlich zu machen, daß die Verkehrsmeldungen, die diese Sender übertragen, sich auf dasselbe engere Straßennetz beziehen. Der Autofahrer kann mit der Tastatur die Bereichskennung und damit die Sender bestimmen, die ihm Verkehrsnachrichten für das Straßennetz übermitteln, in dem er sich gerade bewegt.

Für die weitere Erläuterung wird davon ausgegangen, daß im Empfänger gerade der Suchlaufmode eingeschaltet ist. In diesem Suchlaufmode ist der Lautsprecher 5 in der Regel stummgeschaltet. Hat der Empfänger während des von der Suchlaufsteuerung 8 ausgelösten Suchlaufs den Empfang eines Trägers eines Rundfunksenders festgestellt, so wird der Suchlauf zunächst über eine Leitung 15 zwischen dem HF-Stufenausgang und der Suchlaufsteuerung unterbrochen. In der Vergleichsschaltung 9 wird die vorgewählte Bereichskennung mit dem vom gerade im HF-Teil 2 eingestellten Sender übermittelten Bereichskennung, die am Ausgang des Verkehrsfunkdecoders 6 ansteht, verglichen. Stimmen beide überein, so löst in diesem Koinzidenzfall die Vergleichsstufe 9 einen Impuls aus, mit dem der Suchlaufmode abgeschaltet wird und die Abstimmung auf den Sender erhalten bleibt.

Die Bereichskennung moduliert bekanntlich den 57-kHz-Hilfsträger entsprechend den Normen für den Verkehrsfunk mit 60 % in der Amplitude, die Durchsagekennung die Hilfsträgeramplitude dagegen nur mit 30 %. Diese Tatsache führt dazu, daß schon in alier Regel für die Erkennung der Durchsagekennung eine längere Zeit erforderlich ist als für die Erkennung einer Bereichskennung, erst recht jedoch für die Unterscheidung zweier Durchsagekennungen.

In dem erfindungsgemäßen Rundfunkempfänger wird die Tatsache ausgenutzt, daß am Eingang der Durchsageerkennungsstufe 61 im Verkehrsfunkdecoder 6 während der ganzen Erkennungszeit das noch nicht erkannte Signal bereits ansteht. Beim Auftreten dieses Signals wird die Zeitkonstante für die Fortschaltautomatik 11 verlängert. Dazu liegt das Eingangssignal der Durchsageerkennungstufe 61 des Verkehrsfunkdecoders 6 auch an einem Zeitglied 10 der Fortschaltautomatik 11 an und bewirkt eine Verlängerung der Wartezeit, die für die Erkennung des Kennsignals zur Verfügung steht.

Nach Ablauf dieser Wartezeit wird der Suchlauf wieder automatisch gestartet, sofern die Fortschaltautomatik 11 in der Suchlaufsteuerung 8 nicht durch das Koinzidenzsignal der Vergleichsstufe 9 oder durch die erkannte Durchsagekennung blockiert bleibt. Dazu ist der Ausgang der Durchsageerkennungsstufe 61 parallel zum Ausgang der Vergleichsstufe 9 mit einer vor dem Eingang der Fortschaltautomatik 11 liegenden Oderstufe 12 verbunden.

Wenn die Rundfunksender nicht nur Verkehrsmeldungen übermitteln, sondern auch andere Gefahrenmeldungen, dann sollte deren Empfang unter allen Umständen gewährleistet sein, auch im Suchlaufmode. Für die Kennzeichnung der Übertragung einer solchen Gefahrenmeldung dient eine andere, von 125 Hz abweichende, Durchsagekennung, die den 57-kHz-Hilfsträger zu 30 % in der Amplitude moduliert.

Wird diese zweite Durchsagekennung in einer zweiten Tastatur 13 (oder in einem zweiten Mode der ersten Tastatur 7) vorgewählt, so wird das Signal am Ausgang der Durchsageerkennungsstufe 61 in einer Vergleichsstufe 14 mit der vorgewählten Durchsagekennung verglichen. Im Koinzidenzfall hält dann der Suchlauf mit Sicherheit auf einem Sender, der gerade eine Warnmeldung verbreitet und solange die Warnmeldung ausgestrahlt wird.

## Patentansprüche

1. Rundfunkempfänger mit einem Decoder (6) für Signale, die einem 57-kHz-Hilfsträger aufmoduliert sind, und mit einer auf eine mit dem Hilfsträger übertragenen, vorgegebene Kennung programmierbaren Suchlaufschaltung, die eine Fortschaltautomatik umfaßt, welche den Suchlaufstop nach einer durch die Zeitkonstante eines Zeitgliedes (10) vorgegebenen Wartezeit aufhebt, wenn in dem Signal des aufgesuchten Senders nicht die vorgegebene Kennung erkannt ist, dadurch gekennzeichnet, daß das Zeitglied der Fortschaltautomatik in Abhängigkeit davon, ob während der vorgegebenen Wartezeit die Kennung bereits aufgetreten ist, zwischen verschiedenen Werten der Zeitkonstante umschaltbar ist.

2. Rundfunkempfänger nach Anspruch 1, dadurch gekennzeichnet, daß der Decoder ein Verkehrsfunkdecoder ist, der über eine Durchsageerkennungsstufe (61) verfügt und daß in Abhängigkeit vom Auftreten eines mit einer Durchsagekennung modulierten Signals am Eingang der Durchsageerkennungsstufe (61) im Verkehrsdecoder (6) die Zeitkonstante im Zeitglied (10) in der Suchlaufsteuerung (8) vergrößert ist.

## Claims

1. Broadcast radio receiver having a decoder (6) for signals which are modulated onto a 57 kHz auxiliary carrier, and having a search circuit which is programmable to a predetermined identifier which is transmitted using the auxiliary carrier, and which search circuit comprises an automatic stepping system which cancels the search stop after a waiting time, which is predetermined by the time constant of a timer (10), if the predetermined identifier is not identified in the signal from the transmitter which has been found, characterized in that the timer of the automatic stepping system can be switched over between different time constant values depending on whether the identifier has already occurred during the predetermined waiting time.

2. Broadcast radio receiver according to Claim 1, characterized in that the decoder is a traffic radio decoder which has an announcement identification stage (61), and in that the time constant in the timer (10) in the search controller (8) is increased if a signal which is modulated with an announcement identifier occurs at the input of the announcement identification stage (61) in the traffic decoder (6).

## Revendications

1. Récepteur radio comprenant un décodeur (6) pour des signaux modulés par une porteuse auxiliaire à 57 kHz et un circuit de recherche programmé sur une caractéristique prédéterminée, transmise avec la porteuse auxiliaire, ce circuit comprenant un automatisme de commutation qui supprime le blocage de la recherche après un temps d'attente prédéterminé par la constante de temps d'un élément de temporisation (10), si, dans le signal de l'émetteur recherché, on ne reconnaît pas la caractéristique prédéterminée,
caractérisé en ce que
l'élément de temporisation de l'automatisme de commutation peut être commuté entre différentes valeurs de la constante de temps suivant que la caractéristique est arrivée pendant le temps d'attente prédéterminé.

2. Récepteur radio selon la revendication 1,
caractérisé en ce que
le décodeur est un décodeur de radio de circulation qui dispose d'un étage de reconnaissance de messages (61) et, en fonction de l'arrivée d'un signal modulé par une caractéristique de messages, à l'entrée de l'étage de reconnaissance de messages (61) dans le décodeur de circulation (6), on augmente la constante de temps de l'élément de temporisation (10) dans la commande de recherche (8).
